Europäisches Patentamt

European Patent Office

Office européen des brevets

(19)

(11) Publication number: **0 159 994**
**B1**

## EUROPEAN PATENT SPECIFICATION

(12)

(45) Date of publication of patent specification: **09.03.88**

(21) Application number: **84900672.1**

(22) Date of filing: **09.01.84**

(86) International application number:
**PCT/US84/00026**

(87) International publication number:
**WO 85/02061 09.05.85 Gazette 85/11**

(51) Int. Cl.⁴: $H\ 01\ L\ 29/60$, $H\ 01\ L\ 29/76$

(54) MULTI-GATE FIELD EFFECT TRANSISTOR.

(30) Priority: **28.10.83 US 546335**

(43) Date of publication of application:
**06.11.85 Bulletin 85/45**

(45) Publication of the grant of the patent:
**09.03.88 Bulletin 88/10**

(84) Designated Contracting States:
**DE FR GB NL**

(56) References cited:
**DE-A-3 024 296**

**IEEE Transactions on Electron Devices, vol. ED-25, no. 6, June 1978 (New York, US) Takashi Furutsuka et al.: "GaAs dual-gate MESFETS", pages 580-586, see figure 12**

(73) Proprietor: **Hughes Aircraft Company
7200 Hughes Terrace P.O. Box 45066
Los Angeles California 90045-0066 (US)**

(72) Inventor: **LUNDGREN, Ronald, E.
1484 Norwich Avenue
Thousand Oaks, CA 91360 (US)**

(74) Representative: **Kuhnen, Wacker & Partner
Schneggstrasse 3-5 Postfach 1729
D-8050 Freising (DE)**

EP 0 159 994 B1

Courier Press, Leamington Spa, England.

## Description

Technical Field

The present invention is generally directed to field effect transistors (FETs) having two or more control gates and, in particular, to a multi-gate FET wherein the operation of the device is symmetric regardless of the particular gate that is activated by an applied electrical signal.

Background of the Invention

Field effect transistors having two or more control gates for both digital and analogue applications are generally known. See, for example, Krumm et al, U.S. Patent, 4,313,126, Huang, U.S. Patent 4,040,168, R. L. VanTuyl et al, "Gallium Arsenide Digital Integrated Circuits", Technical Report AFAL—TR—76 (Air Force Contract No. F33615—73—C—1242), October 1976, pp. 27—29, and Nambu et al, "A Low-Noise Dual-Gate GaAs MESFET for UHF TV Tuner", *IEEE Journal of Solid-State Circuits,* Vol. SC—17, No. 4, August 1982, page 648. In IEEE Transactions on Electron Devices, vol. ED—25, No. 6, June 1978, pages 580—586, T. Furutsuka et al describe a multi-gate field effect transistor according to the first part of claim 1. In particular, a performance analysis of GaAs dual-gate MESFETs including DC- and HF-characteristics and noise behaviour is carried out and the fabrication and characterization of a prototype device under the design considerations developed from the analysis is disclosed.

Providing a single FET with multiple control gates permits the application of a corresponding number of control input signals. In digital applications this directly permits the realization of a logic function, such as a multiple input NAND, utilizing a logic cell comprised of only a single transistor. Conventionally, several interconnected transistors are required to provide an equivalent logic cell.

In various applications, utilization of a single-transistor logic cell is highly advantageous. For example, the bandwidth of extremely high-speed integrated circuits is directly limited by the number of transistors required to implement a desired logic function and, therefore, the number of transistors in each logic cell. Also, in integrated circuits where semiconductor substrate surface area is limited, the number of transistors required to implement each logic cell will naturally limit the circuit's overall functional complexity.

In analogue applications, there are similar benefits in using multi-gate FETs. Input signals applied to respective gates of such a FET can be effectively mixed in an essentially single transistor stage. The output signal provided is directly dependent on each of the input signals. However, each of the input signal sources remain effectively isolated from one another as well as from the output.

A principle problem encountered in the use of prior art multi-gate FETs is that they exhibit asymmetric gate characteristics. That is, the electrical behaviour of the device, as evidenced by its output signal, can vary significantly depending on the particular gate to which a given input signal is applied. This is of particular concern when using enhancement mode multigate MESFETs. Typically, the surrounding circuit must be designed to either account for or be tolerant of the asymmetric gate characteristics of a prior art multi-gate FET. In either case, however, the necessary additional design effort and consequential design trade-offs seriously compromise the advantages gained by utilizing multi-gate FETs.

Summary of the Invention

The purpose of the present invention is therefore to provide a multi-gate field effect transistor having symmetrical gate characteristics.

This is accomplished by providing a multi-gate field effect transistor as set out in claim 1, having source and drain regions and a plurality of active channels extending thereinbetween. A like plurality of gates each having a corresponding like plurality of gate contacts commonly overlying the active channels, are provided to control the flow of charge carriers between the source and drain regions. The gate contacts are uniquely ordered and correspondingly positioned with regard to each of the channel regions so that each of the gates has a substantially symmetric electrical characteristic in controlling the flow of charge carriers between the source and drain regions.

An advantage of the present invention is that it provides a multi-gate FET whose electrical behavior is substantially uniform regardless of the particular control gate to which a given input signal is provided.

Another advantage of the present invention is that any number of control gates can be provided in a single multi-gate FET device.

Still another advantage of the present invention is that no additional circuitry is required to ensure the operational symmetry of the control gate characteristics of the multi-gate FET. A further advantage of the present invention is that the multi-gate FET is useful in both digital and analogue applications.

Yet another advantage of the present invention is that the fabrication of the multi-gate FET can be accomplished through the use of conventional processing steps and no additional critical processing steps are required.

Brief Description of the Drawings

Other attendant advantages of the present invention will become apparent and readily understood by reference to the following detailed description when considered in connection with the accompanying drawings, in which like reference numerals designate like parts throughout the figures, and wherein:

FIG. 1a shows the circuit symbol for a dual-gate field effect transistor;

FIG. 1b shows the asymmetrical gate characteristic I—V curves typical of a prior art dual-gate FET.

FIG. 1c shows the symmetrical gate characteristic I—V curve of the gates of a dual-gate FET fabricated in accordance with the present invention.

FIG. 2 shows a top view of one embodiment of a dual-gate field effect transistor constructed in accordance with the present invention;

FIGS. 3a-3c show cross-sections, during fabrication, of a dual-gate FET consistant with the present invention, FIG. 3c being a cross-section of the completed dual-gate field effect transistor shown in FIG. 2;

FIGS. 4—6 show detail portions of the cross-section of FIG. 3 during different phases of the operation of the dual-gate field effect transistor of FIG. 2; and

FIG. 7 shows a top view of a triple-gate field effect transistor constructed in accordance with the present invention.

Detailed Description of the Invention

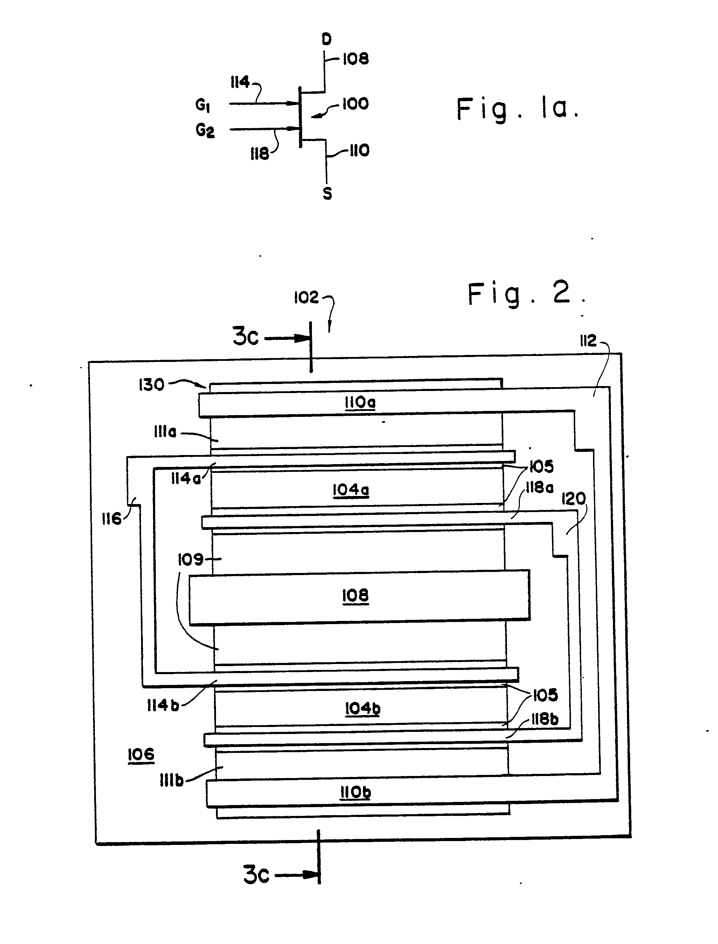

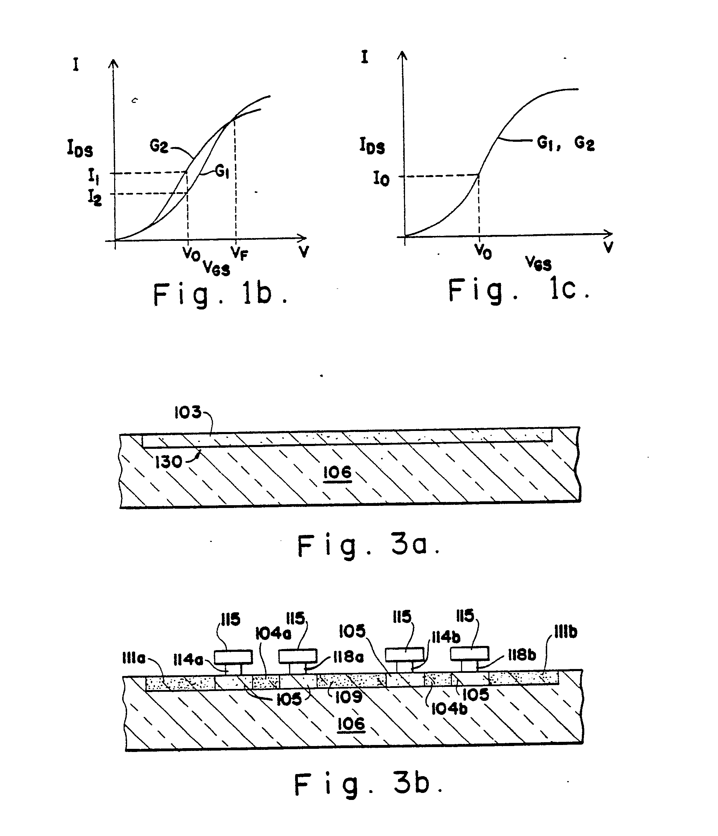

The circuit symbol for a dual-gate FET device 100 is shown in FIG. 1. Analogous to conventional FETs, a pair of control gates 114, 118, labeled $G_1$ and $G_2$ respectively, are provided to control the flow of current between the drain 108 and the source 110 of the dual-gate FET 100. Ideally, the electrical behavior of the FET 100 should be identical with respect to each of the gates 114, 118. However, the gate characteristic I—V curves of prior art devices are typically asymmetric. As shown in FIG. 1b, for a given voltage potential, $V_0$, applied to a particular one of the gates $G_1$, $G_2$, the other gate being maintained at a given voltage potential $V_F$, the current flow $I_1$, $I_2$, respectively attributable thereto, is different. The output voltage, current drive, and time response characteristics are, therefore, similarly asymmetric. Consequently, the utility of prior art dual-gate and, equally, multi-gate FETs is compromised, particularly in linear analogue and high-speed digital applications.

The asymmetry in the gate characteristics of prior art devices is directly linked to the fact that the various control gates are placed at different points along the channel region relative to the source and drain regions. Consider, a voltage gradient will exist along the length of the channel region when the voltage potentials applied to the various gates of a multi-gate FET are such to permit the flow of current between the source and drain regions. The depletion region associated with each gate is dependent, not solely on the voltage potential applied to the gate, but on the potential difference between the gate and its immediately associated portion of the channel region. Therefore, the depletion region widths and, consequently, the current flow attributable thereto for a given gate voltage potential $V_0$ will differ depending on the relative position of the gates.

Gate characteristic symmetry is most critical and highly desirable in high-speed multi-gate enhancement mode GaAs MESFETs. For reasons described below, the gate input voltage potentials are limited to within the approximate range of 0.0 to 0.5V. A gate characteristic asymmetry of 0.1V may and often will effectively defeat the use of such a device. The present invention, however, permits the above described ideal behavior to be obtained in dual-gate and multi-gate FETs by providing a device having symmetric gate characteristics such as shown in FIG. 1c for a dual-gate FET.

It should be understood, however, that the present invention is not limited to GaAs multi-gate MESFETs. Technologies utilizing other substrate materials, such as silicon and indium phosphide, gate materials, such as tungsten silicide, gate structures, such as MOS and JFET, and operating modes, such as depletion mode, as well as various fabrication technologies, such as ion implantation and ion and electron beam lithography, may be advantageously employed consistant with the present invention. However, the multi-gate enhancement mode GaAs MESFET is preferred due to its high potential speed, low power-delay product, low operating voltage and power dissipation, and single required voltage supply. The manner of employing the various alternate technologies will be readily apparent to those skilled in the art in view of the teachings of the present invention. Thus, the present invention will be discussed below particularly in terms of its preferred material, gate structure, operating mode, and manner of fabrication. However, many of the specific and well known processing steps, such as photolithographic resist masking, of the preferred manner of fabrication are not described in detail so as not to obscure the present invention.

Referring now to FIG. 2, a preferred dual-gate FET 102 embodiment of the present invention is shown. The dual-gate FET 102 is formed on a semiconductor substrate 106, preferably semi-insulating gallium arsenide (GaAs). An active layer, generally indicated as 130, source contacts 110a, 110b, drain contact 108, and gate contacts 114a, 114b, 118a, 118b are preferably formed utilizing a self-aligned gate MESFET fabrication process as described in a further US patent application for "Self-Aligned MESFET And The Method Of Fabricating The same", not published prior to the present application and assigned to the assignee of the present invention. Although specifically referred to, the self-aligned gate MESFET fabrication process, as applied to the present invention, is described below for purposes of clarity. Referring generally to FIGS. 3a-c, the following steps are performed:

1. An n-type active channel layer 103 is uniformly ion implanted into a surface of the substrate 106 within an active layer area 130 as shown in FIG. 3a. The ion implant energy and dosage are selected to provide an active channel layer 103 appropriate for normally "off" enhancement mode MESFETs (gate threshold voltage between approximately 0.0V and 0.3V). Preferably, this is accomplished by implanting silicon ions at an energy between approximately 50 and 150KeV to a dosage of between approximately 1.0 $\times 10^{12}/cm^2$ and $5.0 \times 10^{12}/cm^2$.

2. A composite mask layer comprising an etch resistant layer, such as aluminum, silicon nitride or nickel, overlying a metal layer, is formed on the surface of the substrate 106, the etch resistant layer being defined so as to only overlie portions of the active channel layer 103, those portions ultimately being the active channel region 105 of the completed device 102. Consistent with MESFET fabrication, the metal, preferably a titanium-tungsten alloy, is provided so as to form a Schottky barrier contact to the active channel regions 105.

3. A plasma etch is then performed to selectively etch the exposed surfaces of the Schottky metal layer of the composite mask. This results in the etch resistant layer of the composite mask being uniformly undercut. Preferably, the plasma etch is performed such that the undercut surface is undercut at each edge for a distance of between approximately 50 nm and 200 nm (500Å and 2000Å).

4. A second ion implantation is then performed into the active layer area 130 to provide the source 111a, 111b, drain 109, and channel interconnection regions 104a, 104b utilizing the remaining portions 115 of the etch resistant layer as a mask. The implant energy is properly selected to prevent ions from being implanted into the substrate 106 underlying the composite mask. The energy and dosage of this ion implant are further selected to provide highly doped and, therefore, highly conductive regions 104a, 104b, 109, 111a, 111b. Preferably, the regions 104a, 104b, 109, 111a, 111b are doped $n^+$-type by the ion implantation of silicon ions at energies between approximately 50 and 200KeV to a dosage of between approximately $1 \times 10^{13}$ and $1 \times 10^{15}/cm^2$, thereby forming regions 104a, 104b, 109, 111a, 111b having a thickness of between approximately 0.05 µm and 0.3 µm. This stage in the fabrication of the device 102 is shown in FIG. 3b.

5. The etch resistant layer is then removed to leave the remaining portion of the Schottky metal layer, effectively the gate contacts 114a, 114b, 118a, 118b, self-aligned with the active channel regions 105 and slightly spaced apart from the highly doped source 111a, 111b, drain 109 and channel interconnection 104a, 104b regions.

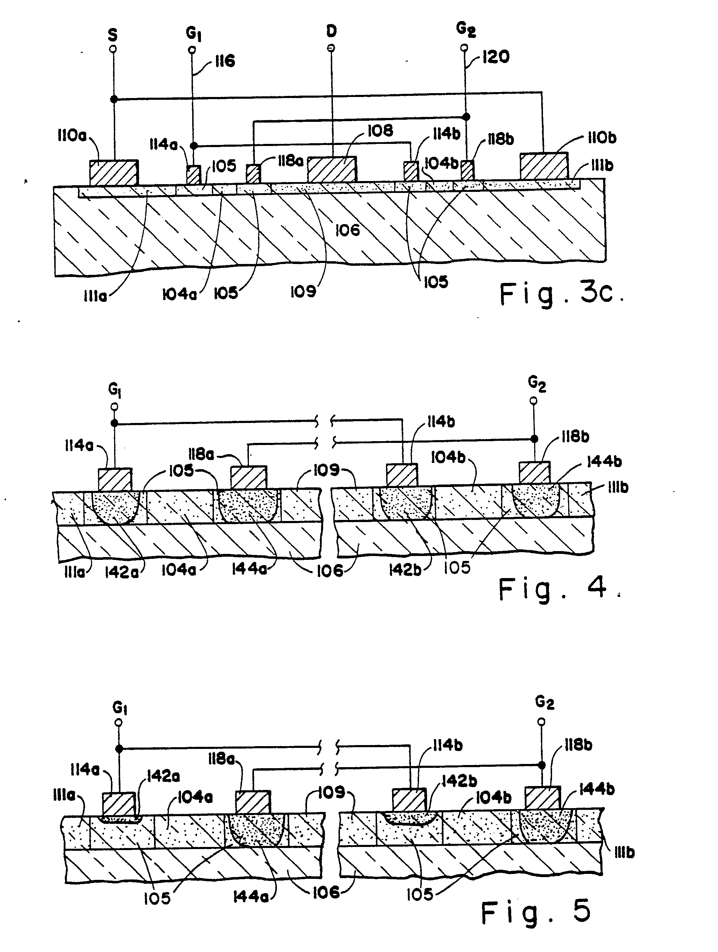

6. Another metalization step is then performed to appropriately provide ohmic source 110a, 110b and drain 108 contacts to the surfaces of the source 111a, 111b and drain 109 regions, respectively, as shown in FIG. 3c.

Referring again to FIG. 2, as shown, the drain contact 108 is centrally located and transversely spans the active layer 130 effectively dividing it into substantially identical active channels. Consistant with the present invention these two active channels may be alternately oriented at a different angle, paralleled, or even spacially separated from one another. However, the linear contiguous configuration shown in FIG. 2 is preferred for reasons of easy fabrication and compactness.

At least a portion of the drain 108, source 110a, 110b, and each of the gate 114a, 114b, 118a, 118b, contacts, and their corresponding drain 109, source 111a, 111b, and channel 105 regions, are associated with each active channel of the active layer 130. Preferably, as shown in FIG. 2, the source contacts 110a, 110b and regions 111a, 111b are symmetrically located transversely spanning the active layer 130 at the ends thereof and, further, conductively interconnected at a source contact pad 112. Similarly, the gate contacts 114a, 114b, 118a, 118b and channel regions 105 transversely span the active layer 130, the gate contact being conductively interconnected at their respective gate contact pads 116, 120. As shown, the gate contacts 114a, 118a and 114b, 118b of the gates $G_1$, $G_2$ are respectively associated with the two active channels of the active layer 130. More generally stated in accordance with the present invention, each active channel of an active layer has associated therewith at least a portion of the source and drain regions and contacts thereto and a gate contact and channel region of each of the gates. Again referring to FIG. 2, the position of the gate contacts 114a, 114b, 118a, 118b, along the length of the active layer 130 with respect to one another and their respective source 111a, 111b and drain 109 regions is of particular importance. The positional relationship is clearly illustrated by considering a gate contact 114a of gate G1 and its corresponding gate 118b of gate G2. Corresponding gate contacts are here defined as gate contacts associated with different gates and active channels but, as will be described below in greater detail, having an equivalent effect on the operational behavior of the multi-gate FET of the present invention. The positional relationship is that for each gate contact 114a positioned at a particular point along the length of its associated active channel there is a corresponding gate contact 118b that is similarly positioned on its associated active channel. Thus, generally stated, the order of the gates, to which the gate contacts are associated, is unique with respect to each active channel and, further the particular position of corresponding gate contacts is substantially the same with respect to their associated source and drain regions.

The reason and effects of the above relationship can best be understood by considering the various phases of the operation of the dual-gate FET 102. Referring now to FIG. 4 showing the pertinent detailed sections of a cross-section of the dual-gate FET 102, Schottky barrier contact depletion regions 142a, 142b, 144a, 144b, are induced in and completely block current conduction through the active channel layer 105 when the drain 108 is biased to a positive voltage potential and the gates $G_1$, $G_2$ are biased to a zero voltage potential with respect to the source 110. This is consistent with the operation of normally "off" enhancement mode MESFETS.

FIG. 5 shows the condition of the depletion regions 142a, 142b when a small positive voltage potential is applied to gate $G_1$ and, therefore, gate contacts 114a and 114b. It should be noted that the positive voltage potential applied to either of the gates $G_1$, $G_2$ is nominally constrained to within the built-in Schottky barrier potential of the gate contacts 114a, 114b, 118a, 118b. Otherwise, excessively large gate currents will flow through the Schottky barrier diodes formed by the gate contacts and, therefore, substantially alter if not defeat the operation of the device 102 as a MESFET. For a positive voltage potential applied to gate $G_1$ less than the built-in barrier potential, a small depletion region 142a, 142b of reduced-width will remain induced beneath the gate contacts 114a, 114b. Inherently, the depletion region 142b associated with the gate contact 114b is wider than that associated with the gate contact 114a. Since the depletion regions 144a, 144b associated with the gate $G_2$ each block the flow of current through their respective active channels, the voltage potential of the channel region 105 associated with the gate contact 114b is substantially that of the drain contact 108 and region 109. Conversely, the voltage of the channel region 105 associated with the gate contact 114a is substantially that of its associated source contact 110a and region 111a. As is well known in the art, the thickness of a depletion region associated with a Schottky barrier diode varies inversely with the potential difference between its metal contact and the underlying portion of the active channel.

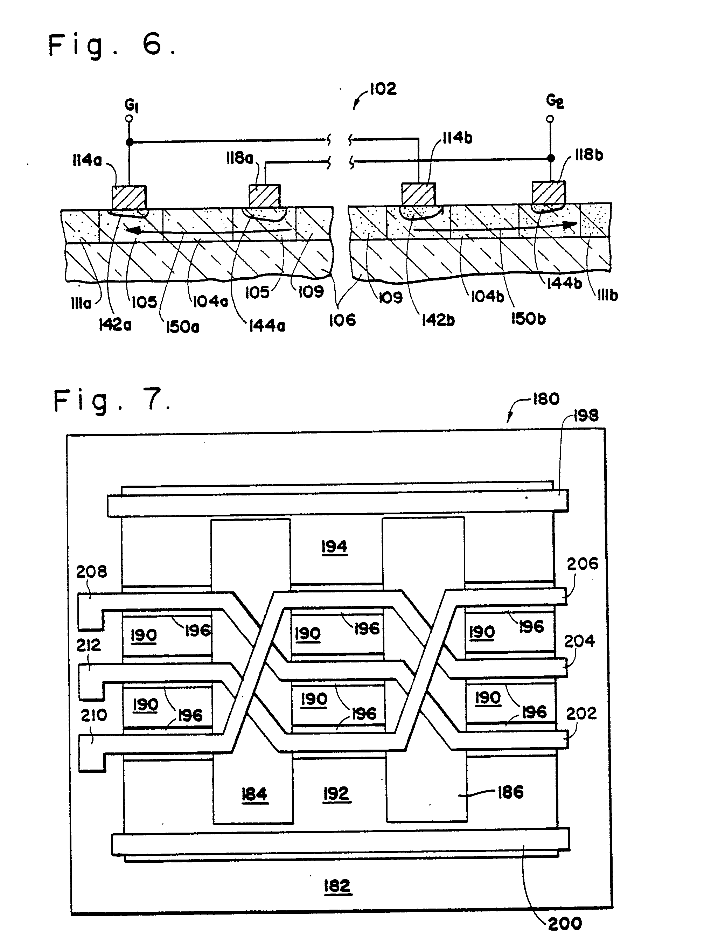

Referring now to FIG. 6, the detail sections show the depletion regions 142a, 142b, 144a, 144b induced in response to a small positive voltage potential applied to each of the gates $G_1$, $G_2$. As shown, the voltage potentials applied to the gates $G_1$, $G_2$ are sufficient to permit a significant amount of current, as indicated by the arrows 150a, 150b, to flow from the drain 108 to the sources 110a, 110b. As with conventional FETs, the magnitude of the current flow is dependent on the potential difference between the source and drain and the effective resistance of the current channel. Considering, for a moment, only the active channel associated with the gate contacts 114a, 118a, the effective resistance seen by the current 150a is primarily dependent on the vertical cross-sectional area of the undepleted portion of the channel regions 105 associated with each of the gates 114a, 118a through which the current 150a flows. The flow of current 150a, however, inherently creates a voltage gradient along the length of the active channel. Consequently, for a given gate voltage potential, the widths of the depletion regions 142a, 144a will be different and, further, the change in these depletion region widths will be different for a change in applied gate voltage potentials.

Considering now the complete dual gate FET 102 detailed in FIG. 6 and its operation consistant with the present invention, each gate $G_1$, $G_2$ is represented by a gate contact 114a, 114b, 118a, 118b associated with each active channel of the active layer 130. As established above, corresponding gate contacts occupy similar positions along their active channels resulting in a unique ordering of the gates with respect to each active channel. The net effect of this unique ordering, generally stated, is that for a given set of gate voltage potentials, there will be a corresponding set of depletion region width sequences, each sequence being associated with a given active channel. The correspondence betwen the actual gates and the particular voltage potential of the set of voltage potentials applied thereto is determinative only of the correspondence between each of the depletion region width sequences and the particular active channel to which each sequence is associated. Thus, for a given set of gate voltage potentials, only a corresponding total amount of active channel current will flow, regardless of the particular correspondence in which the gate voltage potentials are provided to the gates. Consequently, electrical behavior of the dual-gate FET 102 is symmetric with respect to each of the gates $G_1$, $G_2$ and, therefore, will only have a single gate characteristic curve, as shown in FIG. 1c.

The principles of the present invention can be equally applied to multi-gate FETs, such as the triple gate FET 180 shown in FIG. 7. An active layer 190, separated into three active channels by two isolation regions 184, 186, is provided at the surface of a substrate 182. Three gates 202, 204, 206, each having three conductively interconnected gate contact portions respectively associated with the three active channels, are each conductively connected to a respective gate contact pad 208, 210, 212. As shown, each gate contact portion of the gates 202, 204, 206 overlies a channel region 196 that is conductively connected by channel interconnect regions 190 between corresponding portions of a drain region 194 and a source region 192. A drain contact 198 ohmicly contacts the drain region 194. Similarly, a source contact 200 ohmicly contacts the source region 192. Note, for purposes of clarity, an electrical insulating layer provided between the gates 202, 204, 206 as they pass over the isolation regions 184, 186 are not shown.

Consistent with the present invention, the gate contact portions of the gates 202, 204, 206 are uniquely ordered with respect to each active channel of the active layer 190, 192, 194, 196. However, corresponding gate contact portions are substantially identically positioned with respect to their associated portions of the source 192 and drain 194 regions. As with the dual-gate FET 102 described above, the active channels are commonly constrained to a closed set of operating conditions corresponding to the given set of gate voltage potentials provided. Consequently, the overall gate characteristics of the gates 202, 204, 206 are substantially symmetric to one another.

## Example

A dual-gate enhancement mode MESFET essentially identical to that shown in FIG. 2 has been fabricated. Silicon ions were implanted at approximately 100KeV into semi-insulating GaAs to a dosage of approximately $1.6 \times 10^{12}/cm^2$ to form the channel layer. The tungsten-titanium Schottky gate contact layer (10% tungsten by weight) was formed to a thickness of approximately 200 nm (2000Å). An etch resistant nickel layer was formed to a thickness of between 100 and 200 nm (1000 and 2000Å). The gate contacts were photolithographically defined having a gate length of approximately 1.6 μm and were plasma etched back to a gate length of approximately 1.4 μm. Silicon ions were again implanted at approximately 85KeV to a dose of approximately $2 \times 10^{13}/cm^2$ to form the source, drain and channel interconnect regions.

The resulting dual-gate MESFET has a gate voltage threshold of approximately 0.1V and is essentially biased fully on at a gate voltage of 0.6V. The gate characteristic curves obtained by test for each of the gates are essentially identical.

Thus, a multi-gate FET having essentially symmetric gate characteristics with respect to each of the gates and a method of fabricating the multi-gate FET has been described.

It should be understood, of course, that the foregoing disclosure relates only to the preferred embodiments of the present invention and that numerous modifications of the design and substitutions of materials may be made without departing from the nature and scope of the present invention and defined by the claims. For example, the designs set forth in the drawings and described above generally relate to discrete applications of dual and triple gate FETs. The designs may be easily manipulated so as to be more appropriate for higher order multi-gate FETs and for monolithic fabrication as part of an integrated circuit. Also, in the light of the above teachings, those skilled in the art may easily alter the fabrication of the multi-gate FET otherwise consistent with the present invention so as to realize p-type as well as n-type multi-gate MESFETs, MOSFETs, and JFETs operating in either depletion or enhancement mode. It is therefore to be understood that, within the scope of the appended claims, the invention may be practiced otherwise than a specifically described.

## Claims

1. A multi-gate field effect transistor (FET) (102) comprising:
   a) a source region (111a; 111b);
   b) a drain region (109);
   c) a plurality of active channels (104a; 104b) extending between said source (111a; 111b) and drain (109) regions; and
   d) a plurality of gates (116; 120), each having a corresponding like plurality of gate contacts (114a, 114b; 118a, 118b) commonly overlying said active channels (104a; 104b), each active channel (104a; 104b) having associated therewith a gate contact (114a, 118a; 114a, 118b) of each of the gates (116; 120) so as to permit the electrical control of the flow of charge carriers between said source (111a; 111b) and drain (109) regions, characterized in that for each gate contact (114a, 118a; 114b, 118b) positioned at a particular point along the length of its associated active channel (104a; 104b) there is a corresponding gate contact (118b, 114b; 118a, 114a) of each other gate (120; 116), each corresponding gate contact (118b, 114b; 118a, 114a) being associated with a different active channel (104b; 104a) and equivalently positioned on its associated active channel (104b; 104a) so that the electrical characteristics of said gates (116; 120), in controlling the flow of charge carriers, are substantially symmetric.

2. The FET of Claim 1 wherein there is an equal number of said active channels (104a; 104b), said gates (116; 120) and said gate contacts (114a, 114b; 118a, 118b) associated with each said gate (116; 120).

3. The FET of Claim 2 wherein the discrete positions of said gate contacts (114a, 114b; 118a, 118b) are uniformly distributed said source (111a; 111b) and drain (109) regions.

4. The FET of Claim 3 wherein said source (111a, 111b), drain (109), and channel regions (104a; 104b) are formed in a substantially planar semiconductor body (106), said source (111a; 111b) and drain (109) regions comprising n+ type semiconductor material and said active channels (104a; 104b) comprising n type semiconductor material.

5. The FET of Claim 4 wherein said semiconductor body (106) is comprised of semi-insulating GaAs, said source (111a; 111b), drain (109), and active channels (104a; 104b) are comprised of silicon doped GaAs, and said gates (116; 120) are formed overlying said active channels (104a; 104b) so as to form an enhancement mode metal semiconductor field effect transistor.

6. The FET of Claim 5 wherein the number of said active channels (104a; 104b) is two.

## Patentansprüche

1. Mehrfach-Gatter-Feldeffekttransistor (FET) (102), welcher aufweist;
   a) einen Source-Bereich (111a; 111b);
   b) einen Drain-Bereich (109);
   c) eine Mehrzahl von aktiven Kanälen (104a; 104b), die sich zwischen der Source (111a; 111b) und dem Drain-Bereich (109) erstrecken; und
   d) eine Mehrzahl von Gattern (116; 120), von denen jedes eine entsprechende Mehrzahl von Gatterkontakten (114a, 114b; 118a, 118b) hat, die gemeinsam die aktiven Kanäle (104a; 104b) überdecken, wobei jeder aktive Kanal (104a; 104b) einen zugehörigen Gatterkontakt (114a, 118a; 116, 118b) von jedem der Gatter (116; 120) hat, um so die elektrische Steuerung des Ladungsträgerflusses zwischen der Source (111a; 111b) und dem Drain-Bereich (109) zu ermöglichen, dadurch gekennzeichnet, daß für jeden Gatterkontakt (114a, 118a; 114b, 118b) an einem bestimmten Punkt längs der Länge des zugehörigen aktiven Kanals (104a; 104b) ein entsprechender Gatterkontakt (118b, 114b; 118a, 114a) von jedem anderen Gatter (120; 116) positioniert ist, wobei jeder korrespondierende Gatterkontakt (118b, 114b; 118a, 114a) einem unterschiedlichen aktiven Kanal (104b, 104a) zugewiesen ist und auf ihrem zugehörigen aktiven Kanal (104b, 104a) äquivalent positioniert ist, so daß die elektrische Charakteristik der Gatter (116; 120) zur Steuerung des Ladungsträgerflusses im wesentlichen symmetrisch sind.

2. FET nach Anspruch 1, worin eine gleiche Anzahl von aktiven Kanälen (104a; 104b) ist, wobei die Gatter (116; 120) und die Gatterkontakte (114a, 114b; 118a, 118b) mit jedem Gatter (116; 120) zugeordnet sind.

3. FET nach Anspruch 2, worin die diskreten Positionen der Gatterkontakte (114a, 114b; 118a, 118b) gleichmäßig zwischen der Source (111a, 111b) und dem Drain-Bereich (109) verteilt sind.

4. FET nach Anspruch 3, worin die Source (111a, 111b), der Drain (109) und die Kanalbereiche (104a, 104b) in einem im wesentlichen planaren Halbleiterkörper (106) gebildet sind, wobei die Source (111a; 111b) und der Drain- Bereich (109) Halbleitermaterial vom Typ n$^+$ aufweisen und die aktiven Kanäle (104a, 104b) Halbleitermaterial vom Typ n aufweisen.

5. FET nach Anspruch 4, worin der Halbleiterkörper (106) semi-isolierendes GaAs aufweist, die Source (111a; 111b), der Drain (109) und die aktiven Kanäle (104a; 104b) mit Silizium dotiertes GaAs aufweisen und die Gatter (116; 120) die aktiven Kanäle (104a; 104b) überdecken, um so einen Anreicherungs-Mode-Metall-Halbleter-Feldeffekttransistor zu bilden.

6. FET nach Anspruch 5, worin die Anazhl der aktiven Kanäle (104a, 104b) zwei ist.

## Revendications

1. Un transistor à effet de champ (FET) à grilles multiples (102), comprenant:
   a) une région de source (111a; 111b);
   b) une région de drain (109);
   c) un ensemble de canaux actifs (104a; 104b) s'étendant entre les régions de source (111a; 111b) et de drain (109); et
   d) un ensemble de grilles (116; 120), comportant chacune un ensemble similaire correspondant de contacts de grille (114a, 114b; 118a, 118b) recouvrant en commun les canaux actifs (104a; 104b), chaque canal actif (104a; 104b) étant associé à un contact de grille (114a, 118a; 114b; 118b) de chacune des grilles (116; 120), de façon à permettre la commande électrique de la circulation de porteurs de charge entre les régions de source (111a; 111b) et de drain (109), caractérisé en ce que pour chaque contact de grille (114a, 118a; 114b, 118b) placé en un point particulier sur la longueur de son canal actif associé (104a; 104b), il existe un contact de grille correspondant (118b, 114b; 118a, 114a) de chaque autre grille (120; 116), chaque contact de grille correspondant (118b, 114b; 118a, 114a) étant associé à un canal actif différent (104b; 104a) et étant placé de façon équivalente sur son canal actif associé (104b; 104a), de façon que les caractéristiques électriques de ces grilles (116; 120), pour la commande de circulation de porteurs de charge, soient pratiquement symétriques.

2. Le FET de la revendication 1, dans lequel il existe un nombre égal de canaux actifs (104a; 104b), de grilles (116; 120) et de contacts de grille (114a, 114b; 118a, 118b) associés à chaque grille (116; 120).

3. Le FET de la revendication 2, dans lequel les positions discrètes des contacts de grille (114a, 114b; 118a, 118b) sont uniformément réparties entre les régions de source (111a; 111b) et de drain (109).

4. Le FET de la revendication 3, dans lequel les régions de source (111a; 111b), de drain (109) et de canal (104a; 104b) sont formées dans un bloc de semiconducteur pratiquement plan (106), les régions de source (111a; 111b) et de drain (109) consistant en matière semiconductrice de type n+, et les canaux actifs (104a; 104b) consistant en matière semiconductrice de type n.

5. Le FET de la revendication 4, dans lequel le bloc de semiconducteur (106) est formé par du GaAs semi-isolant, la source (111a; 111b), le drain (109) et les canaux actifs (104a; 104b) sont constitués par du GaAs dopé au silicium, et les grilles (116; 120) sont formées de façon à recouvrir les canaux actifs (104a; 104b), pour former un transistor à effet de champ métal-semiconducteur à mode d'enrichissement.

6. Le FET de la revendication 5, dans lequel le nombre des canaux actifs (104a; 104b) est de deux.

Fig. 1a.

Fig. 2.

$I$

$I_{DS}$

$I_1$
$I_2$

G2

G1

$V_0$ $V_{GS}$ $V_F$

$V$

## Fig. 1b.

$I$

$I_{DS}$

$I_0$

$G_1$, $G_2$

$V_0$

$V_{GS}$

$V$

## Fig. 1c.

103

130

106

## Fig. 3a.

115  115  104a  105  115  115  111b

111a  114a  118a  114b  118b

105  109  104b  105

106

## Fig. 3b.

Fig. 3c.

Fig. 4.

Fig. 5

3

Fig. 6.

Fig. 7.